# EUROPEAN PATENT SPECIFICATION

(11) **EP 4 250 514 B1**
(45) Date of publication and mention of the grant of the patent: **02.09.2026**
(21) Application number: 20965670.1
(22) Date of filing: 18.12.2020
(51) Int. Cl.: H02J 7/82, H02J 7/92, H02J 7/94, H02J 7/96, H01M 10/44

(54) **CHARGING METHOD, ELECTRONIC DEVICE AND STORAGE MEDIUM**
LADEVERFAHREN, ELEKTRONISCHE VORRICHTUNG UND SPEICHERMEDIUM
PROCÉDÉ DE CHARGE, DISPOSITIF ÉLECTRONIQUE ET SUPPORT DE STOCKAGE

(43) Date of publication of application: 27.09.2023
(73) Proprietor: Ningde Amperex Technology Limited, Ningde City, Fujian Province 352100 (CN)
(72) Inventor: ZHU, Shan, Ningde City, Fujian Province 352100 (CN); GUAN, Ting, Ningde City, Fujian Province 352100 (CN); WU, Fei, Ningde City, Fujian Province 352100 (CN); YU, Hongming, Ningde City, Fujian Province 352100 (CN)
(74) Representative: Icosa
(86) International application number: PCT/CN2020/137783
(87) International publication number: WO 2022/126657

(56) References cited:
- CN-A- 101 071 887
- CN-A- 105 322 245
- CN-A- 109 065 989
- CN-A- 110 098 646
- CN-A- 110 870 159
- CN-A- 111 293 739
- CN-A- 112 018 463
- US-A1- 2014 159 644
- US-A1- 2021 143 661
- US-B2- 9 627 719

## Description

### TECHNICAL FIELD

This application relates to the field of battery technologies, and in particular, to a charging method, an electronic apparatus, and a storage medium.

### BACKGROUND

In a lithium-ion battery system, internal materials (such as cathode and anode materials and electrolyte) are important parts. During charge-discharge cycles of a battery, the internal materials are consumed by chemical or electrochemical reactions, thus affecting performance of the battery in capacity, rate, and the like. Both the high voltage and duration of high voltage during battery charging affect the chemical or electrochemical reactions in the battery. Existing charging methods such as multi-step charging and ultra-fast charging can improve the battery performance to some extent, but the improvement is limited. For example, the multi-step charging method can shorten the time of the battery being at high voltage. However, the charge rate of the battery continuously decreases, and there is no significant reduction in either the overall charging time or the time of the battery being at high voltage, so that the battery performance is not significantly improved. For another example, the ultra-fast charging method can significantly shorten the charging time, but due to absence of step-by-step charging, the time of the battery being at high voltage is still long, and the improvement in overall performance is still not significant.

CN 101 071 887 A discloses a method for a lead-acid battery, characterized by a process that consists of at least three interconnected charging stages, where each stage employs both a constant current and a constant voltage to charge the battery. In these stages, the charging current decreases sequentially in the constant current phase, while the charging voltage increases progressively during the constant voltage phase. Specifically, the entire charging process typically involves three interconnected stages. Additionally, the method may include a pre-charging stage prior to these three stages, providing an initial phase before the main charging process begins.

CN 109 065 989 A discloses a charging method which includes: charging a battery according to a second current value after charging the battery according to a first current value in each of N charging cycles, the second current value being less than the first current value, and N being a positive integer; and charging the battery according to a target cut-off voltage value in the case where a target voltage value is greater than or equal to the target cut-off voltage value at the end of the N charging cycle. The target voltage value is a charging voltage value corresponding to the first current value, and the target cut-off voltage value is a first cut-off voltage value, or the target voltage value is a charging voltage value corresponding to the second current value, the target cut-off voltage value is a second cut-off voltage value.

### SUMMARY

In view of this, it is necessary to provide a battery charging method, an electronic apparatus, and a storage medium, so as to meet a requirement for fully charging a battery.

According to claim 1, the method of the invention includes: constant-current charging a battery with a first charge current *I*₁ to a first voltage *U*₁ and constant-voltage charging the battery with the first voltage *U*₁ to a first charge cut-off current ${I}_{1}^{′}$; constant-current charging the battery with the first charge current *I*₁ to a second voltage *U*₂; and constant-current charging the battery with a second charge current *I*₂ to a third voltage *U*₃ and constant-voltage charging the battery with the third voltage *U*₃ to a second charge cut-off current ${I}_{2}^{′}$; where *U*₂ is a limited charge voltage of the battery, *U*₂ > *U*₁, *U*₃ *> U*₂, *I*₂ *< I*₁, and ${I}_{1}^{′} \leq {I}_{2}^{′}$*.*

According to some embodiments, the method further includes determining the first voltage *U*₁. The step of determining the first voltage *U*₁ includes: determining a phase change potential *V_{c}* of a cathode material in the battery; obtaining a state of charge of the battery at the phase change potential and determining a corresponding anode potential *Vₐ*; and obtaining a voltage *U_{cv}* of the battery based on the phase change potential *V_{c}* and the anode potential *Vₐ*, where *U_{cv} = V_{c} - Vₐ*, and *U*₁ *= U_{cv}.*

According to some embodiments, the method further includes determining the first charge current *I*₁. The step of determining the first charge current *I*₁ includes: after the battery has been discharged to a fully discharged state, charging the battery with a first preset current at a preset temperature to a fully charged state; discharging the battery with a second preset current to the fully discharged state; after cyclically performing the charging the battery with the first preset current to the fully charged state and discharging the battery with the second preset current to the fully discharged state for a preset number of times, determining whether lithium precipitation occurs on an anode plate of the battery; and if lithium precipitation occurs on the anode plate of the battery, determining that the first preset current is the first charge current *I*₁ of the battery at the preset temperature. According to some embodiments, the step of determining the first charge current *I*₁ further includes: if no lithium precipitation occurs on the anode plate of the battery, adjusting the first preset current; charging the battery with the adjusted first preset current at the preset temperature to the fully charged state; discharging the battery with the second preset current to the fully discharged state; after cyclically performing the charging the battery with the adjusted first preset current to the fully charged state and discharging the battery with the second preset current to the fully discharged state for a preset number of times, determining whether lithium precipitation occurs on the anode plate of the battery; and if lithium precipitation occurs on the anode plate of the battery, determining that the adjusted first preset current is the first charge current *I*₁ of the battery at the preset temperature.

According to some embodiments, *U*₂ *< U*₃ ≤ *U*₂ + 500mV.

According to some embodiments, 0.5*I*₁ *< I*₂ *< I*₁.

According to some embodiments, $0.1 C < {I}_{1}^{′} < 0.6 C$, where C is a charge/discharge rate.

According to some embodiments, $0.1 C < {I}_{2}^{′} < 0.6 C$.

According to some embodiments, the method further includes setting values of the first voltage *U*₁, the second voltage *U*₂, the third voltage *U*₃, the first charge current *I*₁, the second charge current *I*₂, the first charge cut-off current ${I}_{1}^{′}$, and the second charge cut-off current ${I}_{2}^{′}$.

The invention further provides an electronic apparatus accoording to claim 9. The electronic apparatus includes a battery and a processor, where the processor is configured to execute the foregoing charging method to charge the battery.

The invention further provides a storage medium storing at least one computer instruction, where the instruction is loaded by a processor to execute the foregoing charging method, according to claim 10.

In some embodiments, before the voltage of the battery reaches the first voltage, the constant current plus constant voltage charging method is used for charging the battery as much as possible, and then the high-rate constant current charging plus overcharging method is used in the subsequent charging process. This can not only ensure fast charging of the battery, but also shorten the time of the battery being at high voltage, thus alleviating capacity decay of the battery during charge-discharge cycles.

### BRIEF DESCRIPTION OF DRAWINGS

FIG. 1 is a schematic diagram of an electronic apparatus according to an embodiment.
FIG. 2 is a flowchart of a charging method according to an embodiment.
FIG. 3 is a schematic diagram of current change over time during charge according to an embodiment.
FIG. 4 is a schematic diagram of voltage change over time during charge according to an embodiment.
FIG. 5 is a schematic diagram of comparison between battery capacity decays in charging and discharging a battery using a conventional method and the charging method.
FIG. 6 is a diagram of functional modules of a charging system according to an embodiment.

**Reference signs of main components**

| | |
|---|---|
| Electronic apparatus | 1 |
| Charging system | 10 |
| Memory | 11 |
| Processor | 12 |
| Battery | 13 |
| First charging module | 101 |
| Second charging module | 102 |
| Third charging module | 103 |

### DESCRIPTION OF EMBODIMENTS

The following clearly and completely describes technical solutions in some embodiments with reference to the accompanying drawings. Apparently, the described embodiments are some but not all embodiments since the scope of the invention is only defined by the appended claims.

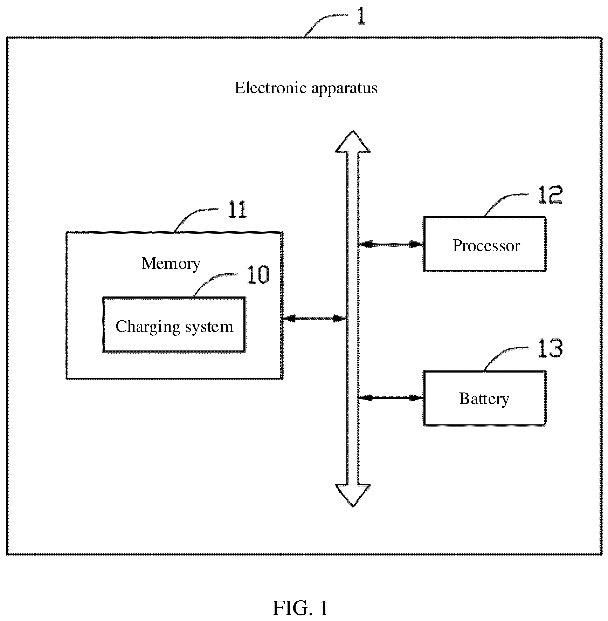

Referring to FIG. 1, FIG. 1 is a schematic diagram of an electronic apparatus according to an embodiment of the invention. Referring to FIG. 1, a charging system 10 runs in an electronic apparatus 1. The electronic apparatus 1 includes but is not limited to a memory 11, at least one processor 12, and a battery 13, where the memory 11, the at least one processor 12, and the battery 13 may be connected to one another through a bus, or may be directly connected.

The battery 13 is a rechargeable battery for supplying electric energy to the electronic apparatus 1. For example, the battery 13 may be a lithium-ion battery, a lithium polymer battery, a lithium iron phosphate battery, or the like. The battery 13 includes at least one battery cell (battery cell) and is appropriate to use a recyclable recharging manner. The battery 13 is logically connected to the processor 12 through a power management system, so as to implement functions such as charging, discharging, and power consumption management through the power management system.

It should be noted that FIG. 1 is only an example for description of the electronic apparatus 1. In other embodiments, the electronic apparatus 1 may instead include more or fewer components or have a different configuration of components. The electronic apparatus 1 may be an electric motorcycle, an electric bicycle, an electric vehicle, a mobile phone, a tablet computer, a personal digital assistant, a personal computer, or any other appropriate rechargeable devices.

Although not shown, the electronic apparatus 1 may further include a wireless fidelity (Wireless Fidelity, Wi-Fi) unit, a Bluetooth unit, a loudspeaker, and other components. Details are not described herein.

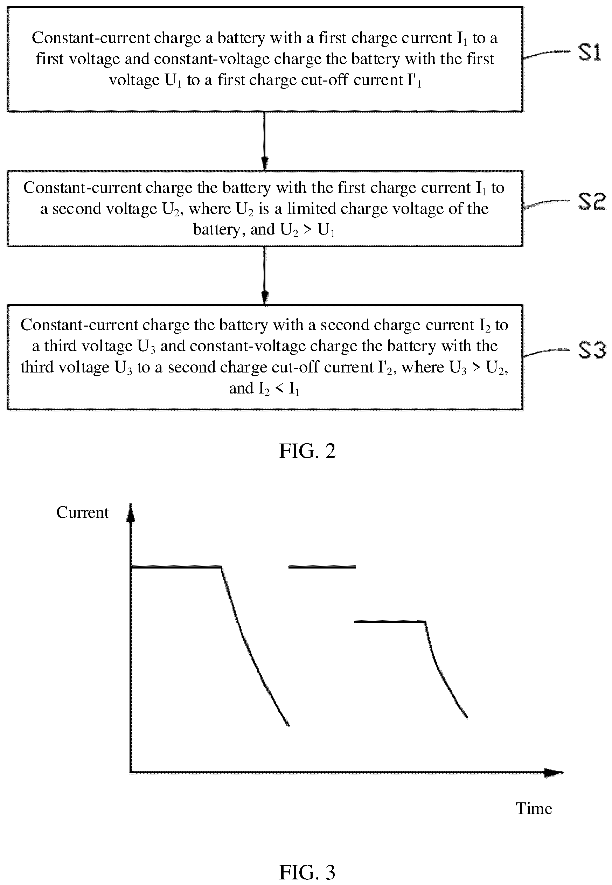

Referring to FIG. 2, FIG. 2 is a flowchart of a battery charging method according to an embodiment of the invention. Depending on different demands, the sequence of steps in the flowchart may be changed, and some steps may be omitted. This application proposes a charging method from a perspective of stability of battery materials during charge, so as to shorten the time of a battery being at high voltage and alleviate capacity decay and polarization growth of the battery during charge-discharge cycles. Specifically, the charging method includes the following steps.

Step S1. Constant-current charge a battery with a first charge current *I*₁ to a first voltage *U*₁ and constant-voltage charge the battery with the first voltage *U*₁ to a first charge cut-off current ${I}_{1}^{′}$*.*

In this embodiment, the constant-current and constant-voltage charging method is used first for charging the battery as much as possible before the voltage of the battery reaches a stable voltage (that is, the first voltage *U*₁). In this way, charging time of the battery after the voltage has become greater than the stable voltage is shortened.

In this embodiment, the method further includes determining the first charge current *I*₁. Specifically, the step of determining the first charge current *I*₁ includes: after the battery has been discharged to a fully discharged state, charging the battery with a first preset current (for example, 1C) at a preset temperature to a fully charged state; discharging the battery with a second preset current (for example, 0.2C) to the fully discharged state; after cyclically performing the charging the battery with the first preset current to the fully charged state and discharging the battery with the second preset current to the fully discharged state for a preset number of times (for example, 5 times), determining whether lithium precipitation occurs on an anode plate of the battery; and if lithium precipitation occurs on the anode plate of the battery, determining that the first preset current is the first charge current *I*₁ of the battery at the preset temperature; or if no lithium precipitation occurs on the anode plate of the battery, adjusting the first preset current (for example, the adjusted first preset current is 1.1C); charging the battery with the adjusted first preset current at the preset temperature to the fully charged state; discharging the battery with the second preset current to the fully discharged state; after cyclically performing the charging the battery with the adjusted first preset current to the fully charged state and discharging the battery with the second preset current to the fully discharged state for a preset number of times (for example, 5 times), determining whether lithium precipitation occurs on the anode plate of the battery; and if lithium precipitation occurs on the anode plate of the battery, determining that the adjusted first preset current (that is, the current at which lithium precipitation just begins as the charge current increases) is the first charge current *I*₁ of the battery at the preset temperature.

It should be noted that the first charge currents at different temperatures may also be determined. Specifically, the first charge currents at different temperatures can be obtained by adjusting the preset temperature and performing the same charging process and lithium precipitation status analysis using the above method for determining the first charge current *I*₁.

In this embodiment, the method further includes determining the first voltage *U*₁. Specifically, the step of determining the first voltage *U*₁ includes: determining a phase change potential *V_{c}* of a cathode material in the battery; obtaining a state of charge of the battery at the phase change potential and determining a corresponding anode potential *Vₐ*; and obtaining a voltage *U_{cv}* of the battery based on the phase change potential *V_{c}* and the anode potential *Vₐ*, where *U_{cv} = V_{c} - Vₐ*, and *U*₁ = *U_{cv}.*

In this embodiment, magnitude of the first charge cut-off current is related to the charging time and charge capacity of the battery. Specifically, to charge as much power as possible before the voltage of the battery reaches a stable voltage to shorten the charging time of the battery, it is necessary to limit the first charge cut-off current ${I}_{1}^{′}$*.* If the first charge cut-off current is excessively small, it takes longer for the voltage of the battery to reach the stable voltage and excessively little power is charged into the battery. If the first charge cut-off current is excessively large, the purpose of charging as much power as possible before the voltage of the battery reaches the stable voltage cannot be achieved. Therefore, $0.1 C < {I}_{1}^{′} < 0.6 C$ , where C is a charge/discharge rate.

It should be noted that the charge/discharge rate refers to a current required for charging to a rated capacity or discharging the rated capacity within a specified time, and is numerically equal to charge/discharge current/rated capacity of battery. For example, when the rated capacity is 10 Ah and the battery discharges at 2 A, the discharge rate of the battery is 0.2C; and when the battery discharges at 20 A, the discharge rate of the battery is 2C. In this embodiment, the fully discharged state means that power in the battery is 0 after the battery is discharged. In another embodiment, the fully discharged state may mean that the battery is discharged to a preset power level.

Step S2. Constant-current charge the battery with the first charge current *I*₁ to a second voltage *U*₂, where *U*₂ is a limited charge voltage of the battery, and *U*₂ *> U*₁.

In this embodiment, after the battery is charged at a constant current and constant voltage to the first voltage U₁, it is necessary to continue charging the battery to the limited charge voltage of the battery (that is, the second voltage *U*₂), where *U*₂ *> U*₁*.* In this way, the high-rate constant current charging plus overcharging method can be used to reduce the time of the battery being at high voltage.

Step S3. Constant-current charge the battery with a second charge current *I*₂ to a third voltage *U*₃ and constant-voltage charge the battery with the third voltage *U*₃ to a second charge cut-off current ${I}_{2}^{′}$, where *U*₃ > *U*₂, and *I*₂ < *I*₁*.*

In this embodiment, after the battery is charged to the limited charge voltage, it is also necessary to charge the battery to the fully charged state. The battery can be charged to the fully charged state by widening the limited charge voltage. To be specific, the limited charge voltage of the battery, the second voltage *U*₂, is widened to the third voltage *U*₃, that is, *U*₃ > *U*₂. However, the third voltage should not be higher than a decomposition potential of electrolyte in a battery cell system of the battery, therefore *U*₂ *< U*₃ ≤ *U*₂ + 500mV. In the case of *U*₃ ≤ *U*₂ + 500mV, no lithium precipitation will occur in the battery. It should be noted that the third voltage *U*₃ is a voltage of the battery in the fully charged state and satisfies *U*₂ *< U*₃ ≤ *U*₂ + 100mV in a preferred embodiment.

Further, after the battery has been charged to the second voltage *U*₂, the battery is charged at a reduced current so that the voltage of the battery reaches the third voltage *U*₃. Therefore, the second charge current *I*₂ is less than the first charge current *I*₁. Further preferably, *U*₂ *< U*₃ ≤ *U*₂ + 100mV.

In this embodiment, the second charge current *I*₂ is a constant charge current for overcharging the battery. It is necessary to consider the second charge current *I*₂ and an overcharge voltage comprehensively to ensure that when the second charge current *I*₂ is used for overvoltage charge, no lithium precipitation occurs at the anode and no overdelithiation occurs at the cathode of the battery. Therefore, the second charge current needs to satisfy 0.5*I*₁ *< I*₂ *< I*₁*.*

In addition, it should be noted that both the method for determining whether lithium precipitation occurs at the anode of the battery and the method for determining that no overdelithiation occurs at the cathode of the battery belong to the prior art. Details are not described herein.

In this embodiment, the second charge cut-off current ${I}_{2}^{′}$ is mainly influenced by the charge capacity. The charge capacity can be guaranteed using the constant voltage cut-off current, and the charging time can also be controlled. The second charge cut-off current satisfies $0.1 C < {I}_{2}^{′} < 0.6 C$, and ${I}_{1}^{′} \leq {I}_{2}^{′}$.

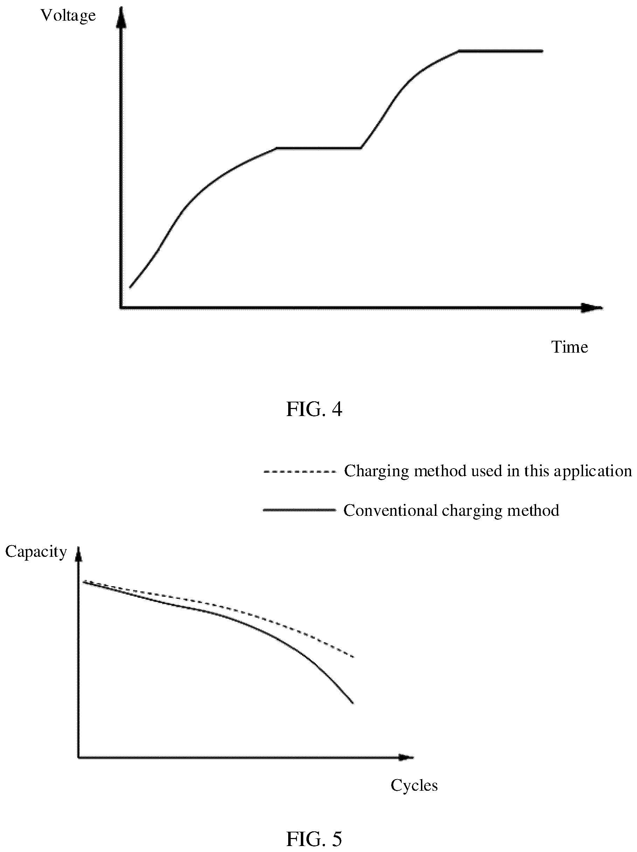

The battery is constant-current charged with the first charge current *I*₁ to the first voltage *U*₁ and the battery is constant-voltage charged with the first voltage *U*₁ to the first charge cut-off current ${I}_{1}^{′}$ ; the battery is constant-current charged with the first charge current *I*₁ to the second voltage *U*₂; and the battery is constant-current charged with the second charge current *I*₂ to the third voltage *U*₃ and the battery is constant-voltage charged with the third voltage *U*₃ to the second charge cut-off current ${I}_{2}^{′}$. In the entire charging process, the current change over time is shown in FIG. 3, and the voltage change over time is shown in FIG. 4. In addition, the constant-current and constant-voltage charging before the voltage of the battery reaches the first voltage may be one-step constant-current and constant-voltage charging or multi-step constant-current and constant-voltage charging. In the case of multi-step charging, the charge voltage is gradually increased and the charge current is gradually reduced. Refer to the existing multi-step charging method.

The charging method further includes setting values of the first voltage *U*₁, the second voltage *U*₂, the third voltage *U*₃, the first charge current *I*₁, the second charge current *I*₂, the first charge cut-off current ${I}_{1}^{′}$, and the second charge cut-off current ${I}_{2}^{′}$.

The charging method provided in this embodiment can greatly reduce the time of the battery being at high voltage and significantly suppress the side reactions of electrode materials, thereby improving the battery performance during cycling.

To make the objectives, technical solutions, and technical effects of the invention clearer, the following further describes this application in detail with reference to the accompanying drawings and examples. It should be understood that the examples provided in this specification are merely intended to interpret the invention. but not intended to limit the invention, which is not limited to the examples provided in this specification, but just to the appended claims.

### Comparative example 1

A conventional charging method (such as a constant-current and constant-voltage charging method) was used to charge the battery. In this example, the ambient temperature was 45°C during the battery charge process.
(1) The battery was constant-current charged with a charge current of 1.5C to 4.4 V.
(2) The battery was constant-voltage charged with a constant charge voltage of 4.4 V to a cut-off current of 0.05C.
(3) The battery was left standing for 5 min.
(4) The battery was constant-current discharged with a discharge current of 0.5C to a discharge cut-off voltage of 3.0 V.
(5) The battery was left standing for 5 min.
(6) The above steps (1) to (5) were cycled 500 times, that is, the battery was subjected to 500 charge-discharge cycles.

### Example 1

The battery charging method provided was used to charge the battery. In this example, the ambient temperature was 45°C during the battery charge process.
(1) The battery was constant-current charged with a charge current of 1.5C to 4.1 V.
(2) The battery was constant-voltage charged with a constant charge voltage of 4.1 V to a cut-off current of 0.2C.
(3) The battery was constant-current charged with a charge current of 1.5C to 4.4V.
(4) The battery was constant-current charged with a charge current of 1C to 4.5 V.
(5) The battery was constant-voltage charged with a constant charge voltage of 4.5 V to a cut-off current of 0.4C.
(6) The battery was left standing for 5 min.
(7) The battery was constant-current discharged with a discharge current of 0.5C to a discharge cut-off voltage of 3.0 V.
(8) The battery was left standing for 5 min.
(9) The above steps (1) to (8) were cycled 500 times, that is, the battery was subjected to 500 charge-discharge cycles.

Referring to FIG. 5, it can be learned that when the conventional charging method is used to charge and discharge the battery, the capacity of the battery decays more as the number of cycles increases; and when the charging method is used to charge and discharge the battery, the capacity of the battery decays less as the number of cycles increases. It can be learned that the charging method can alleviate capacity decay of the battery during charge-discharge cycles.

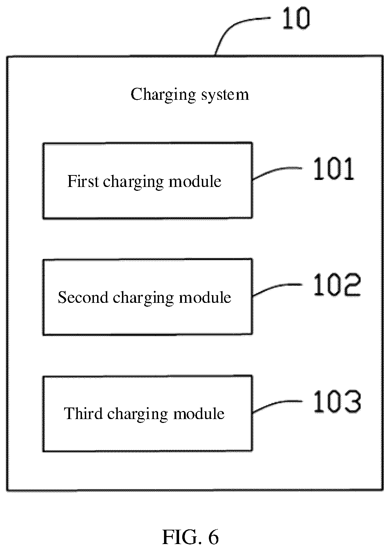

Referring to FIG. 6, in this embodiment, the charging system 10 may be divided into one or more modules, where the one or more modules may be stored in the processor 12, and the processor 12 executes the charging method in some embodiments of this application. The one or more modules may be a series of computer program instruction segments capable of completing particular functions, where the instruction segments are used to describe a process of execution by the charging system 10 in the electronic apparatus 1. For example, the charging system 10 may be divided into a first charging module 101, a second charging module 102, and a third charging module 103 in FIG. 6.

The first charging module 101 is configured to constant-current charge the battery with a first charge current *I*₁ to a first voltage *U*₁ and constant-voltage charge the battery with the first voltage *U*₁ to a first charge cut-off current ${I}_{1}^{′}$*.* The second charging module 102 is configured to constant-current charge the battery with the first charge current *I*₁ to a second voltage *U*₂, where *U*₂ is a limited charge voltage of the battery, and *U*₂ > *U*₁*.* The third charging module 103 is configured to constant-current charge the battery with a second charge current *I*₂ to a third voltage *U*₃ and constant-voltage charge the battery with the third voltage *U*₃ to a second charge cut-off current ${I}_{2}^{′}$, where *U*₃ *> U*₂, *I*₂ < *I*₁, and ${I}_{1}^{′} \leq {I}_{2}^{′}$*.*

With the charging system 10, the time of the battery being at high voltage can be shortened, thus alleviating capacity decay and polarization growth of the battery during charge-discharge cycles. For specific content, reference may be made to the foregoing embodiments of the battery charging method. Details are not described herein again.

In one embodiment, the processor 12 may be a central processing unit (Central Processing Unit, CPU) or another general-purpose processor, a digital signal processor (Digital Signal Processor, DSP), an application-specific integrated circuit (Application Specific Integrated Circuit, ASIC), a field-programmable gate array (Field-Programmable Gate Array, FPGA) or another programmable logic device, a discrete gate or transistor logic device, a discrete hardware component, or the like. The general-purpose processor may be a microprocessor, or the processor 12 may be any other conventional processor or the like.

If implemented in a form of software functional units and sold or used as separate products, the modules in the charging system 10 may be stored in a computer-readable storage medium. Based on such an understanding, all or some of the processes in the method of the above embodiments are accomplished by a computer program instructing relevant hardware. The computer program is stored in a computer readable storage medium, and the computer program, when executed by a processor, can implement the steps of the above method embodiments. The computer program includes computer program code. The computer program code may be in the form of source code, object code, or an executable file or in some intermediate forms or the like. The computer-readable medium may include any entity or means capable of carrying the computer program code, a recording medium, a USB flash drive, a removable hard disk, a magnetic disk, an optical disc, a computer memory, a read-only memory (ROM, Read-Only Memory), a random access memory (RAM, Random Access Memory), or the like.

It can be understood that the module division described above is a logical functional division, and other division manners may be used in actual implementation. In addition, function modules in an embodiment may be integrated into one processing unit, or each of the modules may exist alone physically, or two or more modules may be integrated into one unit. The integrated module may be implemented either in the form of hardware or in the form of hardware plus software function modules.

The one or more modules may alternatively be stored in the memory and executed by the processor 12. The memory 11 may be an internal storage device of the electronic apparatus 1, that is, a storage device built in the electronic apparatus 1. In other embodiments, the memory 11 may alternatively be an external storage device of the electronic apparatus 1, that is, a storage device externally connected to the electronic apparatus 1.

In some embodiments, the memory 11 is configured to: store program code and various data, for example, program code of the charging system 10 installed on the electronic apparatus 1; and implement high-speed automatic access to programs or data during running of the electronic apparatus 1.

The memory 11 may include a random access memory, and may also include a non-volatile memory, for example, a hard disk, an internal memory, a plug-in hard disk, a smart media card (Smart Media Card, SMC), a secure digital (Secure Digital, SD) card, a flash card (Flash Card), at least one disk storage device, a flash memory device, or other non-volatile solid-state storage devices.

It is apparent to those skilled in the art that this invention is not limited to the details of the above illustrative embodiments and that the invention can be implemented in other specific forms which will be part of the invention as long as they fall within the scope defined by the appended claims. Therefore, from whatever point of view, the above embodiments of this application should be regarded as illustrative and non-limiting, and the scope of this application is defined by the appended claims but not the above descriptions.

## Claims

1. A method for charging a battery, the method comprising :
constant-current charging the battery with a first charge current *I*₁ to a first voltage *U*₁ and constant-voltage charging the battery with the first voltage *U*₁ to a first charge cut-off current ${I}_{1}^{′}$;
constant-current charging the battery with the first charge current *I*₁ to a second voltage *U*₂, wherein *U*₂ is a limited charge voltage of the battery, and *U*₂ > *U*₁; and
constant-current charging the battery with a second charge current *I*₂ to a third voltage *U*₃ and constant-voltage charging the battery with the third voltage *U*₃ to a second charge cut-off current ${I}_{2}^{′}$, wherein *U*₃ *> U*₂, *I*₂ < *I*₁, and ${I}_{1}^{′} \leq {I}_{2}^{′}$.

2. The method according to claim 1, **characterized in that**,the method further comprises determining the first voltage *U*₁, and the step of determining the first voltage *U*₁ comprises:
determining a phase change potential *V_{c}* of a cathode material in the battery;
obtaining a state of charge of the battery at the phase change potential and determining a corresponding anode potential *Vₐ*; and
obtaining a voltage *U_{cv}* of the battery based on the phase change potential *V_{c}* and the anode potential *Vₐ*, wherein *U_{cv} = V_{c}* - *Vₐ*, and *U*₁ *= U_{cv}.*

3. The method according to claim 1 or 2, **characterized in that**, the method further comprises determining the first charge current *I*₁, and the step of determining the first charge current *I*₁ comprises:
after the battery has been discharged to a fully discharged state, charging the battery with a first preset current at a preset temperature to a fully charged state;
discharging the battery with a second preset current to the fully discharged state;
after cyclically performing the charging the battery with the first preset current to the fully charged state and discharging the battery with the second preset current to the fully discharged state for a preset number of times, determining whether lithium precipitation occurs on an anode plate of the battery; and
if lithium precipitation occurs on the anode plate of the battery, determining that the first preset current is the first charge current *I*₁ of the battery at the preset temperature.

4. The method according to claim 3, **characterized in that**, the step of determining the first charge current *I*₁ further comprises:
if no lithium precipitation occurs on the anode plate of the battery, adjusting the first preset current;
charging the battery with the adjusted first preset current at the preset temperature to the fully charged state;
discharging the battery with the second preset current to the fully discharged state;
after cyclically performing the charging the battery with the adjusted first preset current to the fully charged state and discharging the battery with the second preset current to the fully discharged state for a preset number of times, determining whether lithium precipitation occurs on the anode plate of the battery; and
if lithium precipitation occurs on the anode plate of the battery, determining that the adjusted first preset current is the first charge current *I*₁ of the battery at the preset temperature.

5. The method according to any one of claims 1 to 4, **characterized in that**, *U*₂ *< U*₃ ≤ *U*₂ + 500mV.

6. The method according to any one of claims 1 to 5, **characterized in that**, 0.5*I*₁ *< I*₂ < *I*₁.

7. The method according to any one of claims 1 to 6, **characterized in that**, $0.1 C < {I}_{1}^{′} < 0.6 C$ , C being a charge/discharge rate.

8. The method according to claim 7, **characterized in that**, $0.1 C < {I}_{2}^{′} < 0.6 C$.

9. An electronic apparatus (1) comprising:
a battery (13);
a power management system; and
a processor (12);
the battery (13) being connected to the processor through a power management system,
wherein the processor is configured to execute the method according to any one of claims 1 to 8 to charge the battery.

10. A storage medium storing at least one computer instruction, wherein the instruction is loaded by a processor (12) to execute the method according to any one of claims 1 to 8, the processor being connected to a battery (13) through a power management system.

## Patentansprüche

1. Verfahren zum Laden einer Batterie, wobei das Verfahren umfasst:
Konstantstrom-Laden der Batterie mit einem ersten Ladestrom *I*₁ bis zu einer ersten Spannung *U*₁ und Konstantspannungs-Laden der Batterie mit der ersten Spannung *U*₁ bis zu einem ersten Ladeabschaltstrom ${I}_{1}^{′}$;
Konstantstrom-Laden der Batterie mit dem ersten Ladestrom *I*₁ bis zu einer zweiten Spannung *U*₂, wobei *U*₂ eine begrenzte Ladespannung der Batterie ist, und *U*₂ *> U*₁; und
Gleichstrom-Laden der Batterie mit einem zweiten Ladestrom *I*₂ bis zu einer dritten Spannung *U*₃ und Gleichspannungs-Laden der Batterie mit der dritten Spannung *U*₃ bis zu einem zweiten Ladeabschaltstrom ${I}_{2}^{′}$, wobei *U*₃ *> U*₂, *I*₂ *< I*₁, und ${I}_{1}^{′} \leq {I}_{2}^{′}$.

2. Verfahren nach Anspruch 1, **dadurch gekennzeichnet, dass** das Verfahren ferner das Bestimmen der ersten Spannung *U*₁ umfasst, und der Schritt des Bestimmens der ersten Spannung *U*₁ umfasst:
Bestimmen eines Phasenänderungspotenzials *V_{c}* eines Kathodenmaterials in der Batterie;
Erhalten eines Ladezustands der Batterie am Phasenwechselpotenzial und Bestimmen eines entsprechenden Anodenpotenzials *Vₐ*; und
Erhalten einer Spannung *U_{cv}* der Batterie basierend auf dem Phasenwechselpotenzial *V_{c}* und dem Anodenpotenzial *Vₐ*, wobei *U_{cv} = V_{c}* - *Vₐ*, und *U*₁ *= U_{cv}.*

3. Verfahren nach Anspruch 1 oder 2, **dadurch gekennzeichnet, dass** das Verfahren ferner das Bestimmen des ersten Ladestroms *I*₁ umfasst, und der Schritt des Bestimmens des ersten Ladestroms *I*₁ umfasst:
nach dem die Batterie bis zu einem vollständig entladenen Zustand entladen wurde, Laden der Batterie mit einem ersten voreingestellten Strom bei einer voreingestellten Temperatur bis zu einem vollständig geladenen Zustand;
Entladen der Batterie mit einem zweiten voreingestellten Strom bis zum vollständig entladenen Zustand;
nach dem zyklischen Durchführen des Ladens der Batterie mit dem ersten voreingestellten Strom bis zum vollständig geladenen Zustand und Entladen der Batterie mit dem zweiten voreingestellten Strom bis zum vollständig entladenen Zustand für eine voreingestellte Anzahl von Malen, Bestimmen, ob eine Lithiumausfällung auf einer Anodenplatte der Batterie auftritt; und
wenn eine Lithiumausfällung auf der Anodenplatte der Batterie auftritt, Bestimmen, dass der erste voreingestellte Strom der erste Ladestrom *I*₁ der Batterie bei der voreingestellten Temperatur ist.

4. Verfahren nach Anspruch 3, **dadurch gekennzeichnet, dass** der Schritt des Bestimmens des ersten Ladestroms *I*₁ ferner umfasst:
wenn keine Lithiumausfällung auf der Anodenplatte der Batterie auftritt, Anpassen des ersten voreingestellten Stroms;
Laden der Batterie mit dem angepassten ersten voreingestellten Strom bei der voreingestellten Temperatur bis zum vollständig geladenen Zustand;
Entladen der Batterie mit dem zweiten voreingestellten Strom bis zum vollständig entladenen Zustand;
nach dem zyklischen Durchführen des Ladens der Batterie mit dem angepassten ersten voreingestellten Strom bis zum vollständig geladenen Zustand und Entladen der Batterie mit dem zweiten voreingestellten Strom bis zum vollständig entladenen Zustand für eine voreingestellte Anzahl von Malen, Bestimmen, ob eine Lithiumausfällung auf der Anodenplatte der Batterie auftritt; und
wenn eine Lithiumausfällung auf der Anodenplatte der Batterie auftritt, Bestimmen, dass der angepasste erste voreingestellte Strom der erste Ladestrom *I*₁ der Batterie bei der voreingestellten Temperatur ist.

5. Verfahren nach einem der Ansprüche 1 bis 4, **dadurch gekennzeichnet, dass** *U*₂ *< U*₃ ≤ *U*₂ *+ 500mV.*

6. Verfahren nach einem der Ansprüche 1 bis 5, **dadurch gekennzeichnet, dass** 0,5*I*₁ *< I*₂ *< I*₁*.*

7. Verfahren nach einem der Ansprüche 1 bis 6, **dadurch gekennzeichnet, dass** $0 , 1 C < {I}_{2}^{′} < 0 , 6 C$ ist, wobei C eine Lade-/Entladerate ist.

8. Verfahren nach Anspruch 7, **dadurch gekennzeichnet, dass** $0 , 1 C < {I}_{2}^{′} < 0 , 6 C$*.*

9. Elektronische Einrichtung (1), umfassend:
eine Batterie (13);
ein Energiemanagementsystem; und
einen Prozessor (12);
wobei die Batterie (13)
über ein Energiemanagementsystem mit dem Prozessor verbunden ist,
wobei der Prozessor so konfiguriert ist, dass er das Verfahren nach einem der Ansprüche 1 bis 8 zum Laden der Batterie ausführt.

10. Speichermedium, das mindestens eine Computeranweisung speichert, wobei die Anweisung von einem Prozessor (12) geladen wird, um das Verfahren nach einem der Ansprüche 1 bis 8 auszuführen, wobei der Prozessor über ein Energiemanagementsystem mit einer Batterie (13) verbunden ist.

## Revendications

1. Procédé de charge d'une batterie, le procédé comprenant :
une charge à courant constant de la batterie avec un premier courant de charge I₁ jusqu'à une première tension U₁ et une charge à tension constante de la batterie avec la première tension U₁ jusqu'à un premier courant de coupure de charge ;
une charge à courant constant de la batterie avec le premier courant de charge I₁ jusqu'à une deuxième tension U₂, où U₂ est une tension de charge limitée de la batterie, et U₂ > U₁ ; et
une charge à courant constant de la batterie avec un deuxième courant de charge I₂ jusqu'à une troisième tension U₃ et une charge à tension constante de la batterie avec la troisième tension U₃ jusqu'à un deuxième courant de coupure de charge, où U₃ > U₂, I₂ < I₁, et le deuxième courant de coupure de charge ≤ le premier courant de coupure de charge.

2. Procédé selon la revendication 1, **caractérisé en ce que** le procédé comprend en outre la détermination de la première tension U₁, l'étape de détermination de la première tension U₁ comprenant :
la détermination d'un potentiel de changement de phase Vc d'un matériau de cathode dans la batterie ;
l'obtention d'un état de charge de la batterie au potentiel de changement de phase et la détermination d'un potentiel d'anode correspondant Va ; et
l'obtention d'une tension Ucv de la batterie basée sur le potentiel de changement de phase Vc et le potentiel d'anode Va, où Ucv = Vc - Va, et U₁ = Ucv.

3. Procédé selon la revendication 1 ou 2, **caractérisé en ce que** le procédé comprend en outre la détermination du premier courant de charge I₁, l'étape de détermination du premier courant de charge I₁ comprenant :
après que la batterie a été déchargée jusqu'à un état complètement déchargé, chargement de la batterie avec un premier courant prédéfini à une température prédéfinie jusqu'à un état complètement chargé ;
décharge de la batterie avec un deuxième courant prédéfini jusqu'à l'état complètement déchargé ;
après avoir exécuté cycliquement le chargement de la batterie avec le premier courant prédéfini jusqu'à l'état complètement chargé et la décharge de la batterie avec le deuxième courant prédéfini jusqu'à l'état complètement déchargé pendant un nombre prédéfini de fois, déterminer si un dépôt de lithium se produit sur une plaque d'anode de la batterie ; et
s'il se produit un dépôt de lithium sur la plaque d'anode de la batterie, déterminer que le premier courant prédéfini est le premier courant de charge I₁ de la batterie à la température prédéfinie.

4. Procédé selon la revendication 3, **caractérisé en ce que** l'étape de détermination du premier courant de charge I₁ comprend en outre :
s'il ne se produit pas de dépôt de lithium sur la plaque d'anode de la batterie, ajuster le premier courant prédéfini ;
charger la batterie avec le premier courant prédéfini ajusté à la température prédéfinie jusqu'à l'état complètement chargé ;
décharger la batterie avec le deuxième courant prédéfini jusqu'à l'état complètement déchargé ;
après avoir exécuté cycliquement le chargement de la batterie avec le premier courant prédéfini ajusté jusqu'à l'état complètement chargé et la décharge de la batterie avec le deuxième courant prédéfini jusqu'à l'état complètement déchargé pendant un nombre prédéfini de fois, déterminer si un dépôt de lithium se produit sur la plaque d'anode de la batterie ; et
s'il se produit un dépôt de lithium sur la plaque d'anode de la batterie, déterminer que le premier courant prédéfini ajusté est le premier courant de charge I₁ de la batterie à la température prédéfinie.

5. Procédé selon l'une quelconque des revendications 1 à 4, **caractérisé en ce que** U₂ < U₃ ≤ U₂ + 500 mV.

6. Procédé selon l'une quelconque des revendications 1 à 5, **caractérisé en ce que** 0,5 I₁ < I₂ < I₁.

7. Procédé selon l'une quelconque des revendications 1 à 6, **caractérisé en ce que** 0,1 C < le premier courant de coupure de charge < 0,6 C, où C est un taux de charge/décharge.

8. Procédé selon la revendication 7, **caractérisé en ce que** 0,1 C < le deuxième courant de coupure de charge < 0,6 C.

9. Dispositif électronique (1), comprenant :
une batterie (13) ;
un système de gestion de l'énergie ; et
un processeur (12) ;
où la batterie (13) est connectée au processeur via un système de gestion de l'énergie,
où le processeur est configuré pour exécuter le procédé selon l'une quelconque des revendications 1 à 8 pour charger la batterie.

10. Support de stockage qui stocke au moins une instruction informatique, où l'instruction est chargée par un processeur (12) pour exécuter le procédé selon l'une quelconque des revendications 1 à 8, le processeur étant connecté à une batterie (13) via un système de gestion de l'énergie.
